# EUROPEAN PATENT APPLICATION

(11) **EP 3 177 120 A1**
(43) Date of publication of application: **07.06.2017**
(21) Application number: 15306919.0
(22) Date of filing: 03.12.2015
(51) Int. Cl.: H05K 5/02, H05K 7/14, H01P 5/02, H01Q 1/24

(54) **NETWORK DEVICE INCLUDING AN INTEGRATED ANTENNA**

(71) Applicant: Thomson Licensing, 92130 Issy-les-Moulineaux (FR)
(72) Inventor: Persoons, Bart, 2650 Edegem (BE)
(74) Representative: Huchet, Anne

(57) **Abstract**

The network device (1) comprises a housing with a cover wall (4), a printed circuit board (5), a standoff (6) for securing the printed circuit board (5) inside the housing and an antenna (8) fixed on the cover wall (4), wherein the standoff (6) is electrically conductive and the antenna (8) is electrically connected via a first conductor path (30) fixed at the housing and via the standoff (6) with a second conductor path (33) of the printed circuit board (5).

## Description

### TECHNICAL FIELD

The disclosure relates to a network device including an antenna for a wireless data transmission.

### BACKGROUND

Access gateways are widely used to connect devices in a home to the Internet or any other wide area network (WAN). Access gateways use for example digital subscriber line (DSL) technology that enables a high data rate transmission over copper lines or via optical fiber. Access gateways including wireless technology have a key role in today's home and professional environments. A mechanism for connecting wireless devices to a wireless local area network (WLAN) is called Wi-Fi, which is a brand name of a Wi-Fi Alliance for devices using a IEEE 802.11 family of standards for a wireless data transmission.

US 7,750,857 discloses a mobile terminal including a terminal casing with a first casing and a second casing combined with the first casing; an external antenna mounted on an external surface of the terminal casing; an internal antenna mounted within the terminal casing; and at least one fastening screw that fastens the first and second casings and electrically connects the external and internal antennas.

It is desirable to provide a network device including an antenna, which can be easily manufactured in a cost effective manner.

### SUMMARY

The network device comprises a housing with a cover wall, a printed circuit board (PCB), a standoff for securing the PCB inside the housing, and an antenna fixed on the cover wall, wherein the standoff is electrically conductive and the antenna is electrically connected via a first conductor path fixed at the housing and via the standoff with a second conductor path of the PCB. The cover wall is for example a bottom cover, a top cover or a side cover.

In a preferred embodiment, the standoff and a side cover of the housing are manufactured together with a top cover or a bottom cover as one piece, the standoff includes a third conductor path fixed at its side wall, and the antenna is connected via the first conductor path and the third conductor path with a contact patch on top of the standoff for providing an electrical connection with the second conductor path of the PCB.

### BRIEF DESCRIPTION OF THE DRAWINGS

Preferred embodiments of the disclosure are explained in more detail below by way of example with reference to schematic drawings, which show:
- Fig. 1: a network device in a cross section comprising a housing, a printed circuit board and an antenna,
- Fig. 2: a top cover of a network device comprising an antenna, and
- Fig. 3: the network device 1 of figure 1 in a cross section in more detail.

### DETAILED DESCRIPTION OF PREFERRED EMBODIMENTS

The present description illustrates the principles of the present disclosure. It will thus be appreciated that those skilled in the art will be able to devise various arrangements that, although not explicitly described or shown herein, embody the principles of the disclosure and are included within its scope.

All examples and conditional language recited herein are intended for instructional purposes to aid the reader in understanding the principles of the disclosure and the concepts contributed by the inventors to furthering the art, and are to be construed as being without limitation to such specifically recited examples and conditions.

Moreover, all statements herein reciting principles, aspects, and embodiments of the disclosure, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

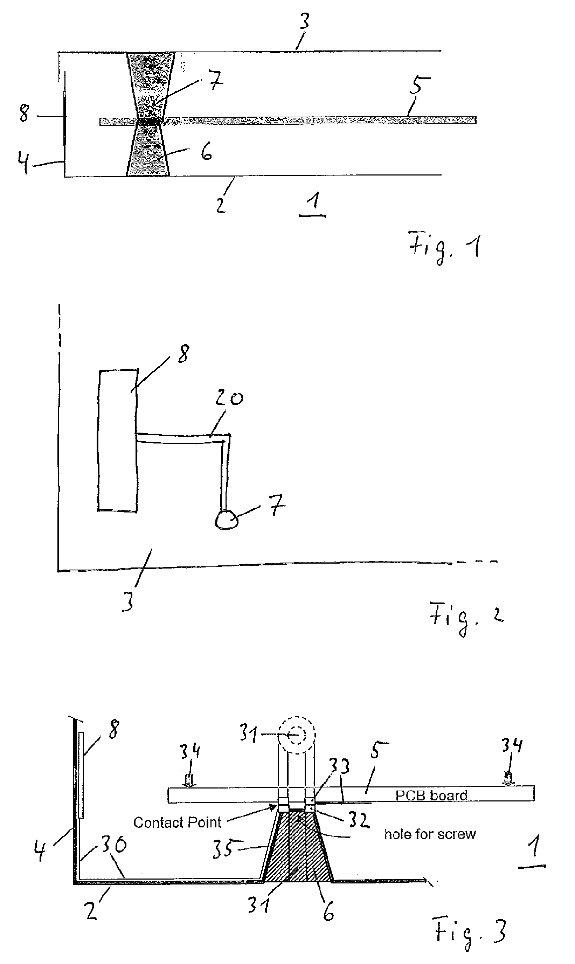

In figure 1, a network device 1 is schematically illustrated in a vertical cross section comprising a housing with cover walls: a bottom cover 2, a top cover 3 and a side cover 4, a printed circuit board (PCB) 5 comprising electronic circuits and an antenna 8. The network device 1 is for example a tablet PC, a laptop, a mobile phone or a CPE device, (an access gateway, a Wi-Fi repeater or a Wi-Fi video bridge, and the like. The antenna 8 is fixed in this embodiment on the side cover 4 and is designed in particular for a wireless transmission and reception in accordance with one of the IEEE 802.11 standards, or in accordance with a mobile phone standard, e.g. a Universal Mobile Telecommunications System (UMTS) or a Long Term Evolution (LTE) standard. The antenna 8 is for example a patch antenna.

The covers 2-4 of the housing consist of a non-conductive material, for example a plastic material. In this embodiment, the housing consists of two parts, a bottom part including the bottom cover 2 and the side cover 4, and a top part representing the top cover 3. Via screws (not shown) the PCB 5 is firmly fixed via standoffs, including first and second standoffs 6 and 7, between the top cover 3 and the bottom cover 2.

The bottom cover 2 is separated from the PCB 5 in this embodiment by the first standoff 6 and the top cover 3 is separated from the printed circuit board 5 by the second standoff 7, wherein both standoffs 6, 7 provide a mechanical connection of the PCB 5 with the top and bottom covers 2, 3 for fixing the PCB 5. The standoff 6 is electrically conductive and connects in this embodiment with a conductor path (not shown) of the PCB 5. The antenna 8 is connected with the standoff 6 via another conductor path (not shown) provided on the side cover 4 and bottom cover 2 and connects the antenna 8 with the conductor path of the PCB 5 via the standoff 6. The conductor path of the PCB is coupled for example with an input of a tuner circuit and/or a transmitter circuit, so that the network device 1 is enabled for wireless reception and/or wireless transmission of data via the antenna 8 and the standoff 6. The antenna 8 and conductor paths of the side cover 4 and the bottom cover 2 are fixed for example by gluing or using a printing technology.

The standoffs 6, 7 include in particular holes (not shown) via which the housing of the network device 1 is closed by screwing the bottom cover 2, the PCB 5 and top cover 3 together, wherein the standoffs 6, 7 separate the PCB 5 from the bottom and top covers 2, 3. Alternatively, a snap-in mechanism is used for the covers 2-4 to close the housing, the snap-in mechanism providing a pressing force between the standoff 6, the PCB 5 and the bottom cover 2. By closing the housing, a force is provided between the standoffs 6, 7 and the PCB 5, so that an electrical connection between the post 6 and the PCB 5 is provided via a contact pressure.

The network device 1 is in particular an access gateway and the antenna 8 a Wi-Fi antenna or an LTE antenna. A respective antenna could have been arranged also on the PCB 5, but by arranging the antenna 8 on the side cover 4, or alternatively on the bottom or top covers 2, 3, an improved electrical performance, in particular with less interference, can be obtained. With the arrangement, therefore a cost efficient implementation of an off-board antenna design can be provided, allowing an easy manufacturing. No soldering of any connection cable or any expensive cable connector is required for connecting the antenna 8 with the conductor path of the PCB 5. No mechanical springs are required.

In figure 2, another embodiment is illustrated schematically in a bottom view, wherein the antenna 8 is fixed on the inside of the top cover 3 and is connected with the standoff 7 via a conductor path 20 fixed on the top cover 3. The standoff 7 is for example a metallic standoff, a plastic standoff covered with an electric coating, or comprises an electrical conductor path for connecting the conductor path 20 with the PCB (not shown). The conductor path 20 is for example a strip conductor, e.g. a copper line.

In figure 3, a more detailed view of the network device of figure 1 is depicted in a vertical cross section. For same elements, same reference numerals are used. In this embodiment, the side cover 4, the bottom cover 2 and the standoff 6 are made in one part representing the lower part of the housing and consist of a plastic material. The antenna 8 is fixed at the inside of the side cover 4.

The standoff 6 includes a central hole 31, via which the PCB 5 can be fixed with a screw to the standoff 6. The top of the standoff 6 is conductive, for example by using a conductor patch 32 on top of the standoff 6. The standoff 6 comprises in this embodiment a conductor path 35, being a strip conductor connecting the conductor path 30 with the conductor patch 32. The antenna 8 is therefore connected via the conductor path 30 fixed inside the side cover 4 and the bottom cover 2, the conductor path 30 leading from the antenna 8 via the side cover 4, the bottom cover 2 and the conductor path 35 of the standoff 6 to the conductor patch 32. The PCB 5 includes a conductor path 33 providing an electrical connection with the conductor patch 32 via a pressing force 34 providing a contact pressure between the conductor path 33 and the conductor patch 32, when the PCB 5 and the bottom cover 2 are screwed together.

The conductor path 33 of the PCB 5 is coupled with electronic circuits of the network device 1, so that the network device 1 is enabled for wireless reception and/or transmission of data via the antenna 8, when the PCB 5 is fixed with the bottom cover 2 via the post 6. The disclosure provides therefore a cost effective solution for connecting the antenna 8 with the electronic circuits of the PCB 5, including an easy manufacturing.

Also other embodiments may be utilized by one skilled in the art without departing from the scope of the present disclosure. The disclosure is in particular applicable for an access gateway, but may be applied also for any other network device including an antenna for a wireless data communication. The disclosure resides therefore in the claims herein after appended.

## Claims

1. A network device (1) comprising
a housing with a cover wall (4);
a printed circuit board (PCB) (5);
a standoff (6; 7) for securing the PCB inside the housing; and
an antenna (8) fixed on the cover wall (4);
**characterized that**
the standoff (6; 7) is electrically conductive, and
the antenna (8) is electrically connected via a first conductor path (20; 30) fixed at the housing and via the standoff (6; 7) with a second conductor path (33) of the PCB.

2. The network device of claim 1, wherein the antenna (8) and the first conductor path (20; 30) are printed or glued on the housing.

3. The network device of claim 1 or 2, wherein the standoff (6; 7) is a metallic standoff, a standoff comprising a conductive coating, or a standoff comprising a third conductor path (35) fixed at its side wall.

4. The network device of claim 3, wherein the antenna (8) is connected via the first conductor path (30) and the third conductor path (35) with a contact patch (32) on top of the standoff (6), the contact patch (32) providing an electrical connection with the second conductor path (33).

5. The network device of one of the preceding claims, wherein the electrical connection between the standoff (6; 7) and the second conductor path (33) is provided via a contact pressure.

6. The network device of one of the preceding claims, wherein the housing consists of a non-conductive material.

7. The network device of one of the preceding claims, wherein the antenna (8) fixed at the inside of the cover wall, and wherein the cover wall is a bottom cover (2), a top cover (3) or a side cover (4).

8. The network device of one of the preceding claims, wherein the antenna (8) is a patch antenna.

9. The network device of one of the preceding claims, wherein the standoff (6) and a side cover (4) of the housing are manufactured together with a top cover or a bottom cover (2) as one piece.

10. The network device of one of the preceding claims, wherein the PCB is fixed inside the housing with the standoff (6, 7) via a screw.

11. The network device of one of the preceding claims, wherein the first conductor path (20; 30) is a strip conductor.

12. The network device of one of the preceding claims, wherein the antenna (8) is an antenna for a wireless data communication according to an Institute of Electrical and Electronics Engineers (IEEE) 802.11 standard or a Long Term Evolution (LTE) standard.
